# EUROPÄISCHE PATENTSCHRIFT

(11) **EP 0 857 405 B1**
(45) Veröffentlichungstag und Bekanntmachung des Hinweises auf die Patenterteilung: **31.03.1999**
(21) Anmeldenummer: 96934779.8
(22) Anmeldetag: 22.10.1996
(51) Int. Cl.: H05K 7/20

(54) **LUFT-WASSER-WÄRMETAUSCHER FÜR EINEN SCHALTSCHRANK**
AIR-WATER HEAT EXCHANGER FOR A SWITCHGEAR CABINET
ECHANGEUR DE CHALEUR AIR-EAU POUR ARMOIRE DE DISTRIBUTION

(30) Priorität: 28.10.1995 DE 19540297
(43) Veröffentlichungstag der Anmeldung: 12.08.1998
(73) Patentinhaber: Rittal-Werk Rudolf Loh GmbH & Co. KG, 35745 Herborn (DE)
(72) Erfinder: SCHNEIDER, Stefan, D-35080 Bad Endbach (DE); PAWLOWSKI, Adam, D-35713 Eschenburg (DE)
(74) Vertreter: Fleck, Hermann-Josef, Dr.-Ing.
(86) Internationale Anmeldenummer: EP9604578
(87) Internationale Veröffentlichungsnummer: WO9716949

(56) Entgegenhaltungen:
- DE-C- 4 008 838
- DE-U- 8 805 202
- DE-U- 9 200 134
- FR-A- 2 648 306

## Beschreibung

Die Erfindung betrifft einen Luft-Wasser-Wärmetauscher mit einer Tauschereinheit und einem Gebläse, die in einem aus Wanne und Haube gebildeten und mit der Deckwand eines Schaltschrankes verbindbaren Gehäuse untergebracht sind, wobei die Deckwand des Schaltschrankes und der Boden der Wanne mit zur Deckung bringbaren Öffnungen versehen sind und wobei das Gehäuse mittels Trennwänden in eine Eingangs- und eine Ausgangskammer unterteilt sind, die mit den Öffnungen im Boden der Wanne in Verbindung stehen.

Ein Luft-Wasser-Wärmetauscher dieser Art ist durch die DE 40 08 838 C1 bekannt. Bei diesem bekannten Luft-Wasser-Wärmetauscher befindet sich die Tauschereinheit in der Eingangskammer und das Gebläse in der Ausgangskammer.

Trennwände und Umlenkbleche sorgen in der Eingangs- und der Ausgangskammer dafür, daß die zu kühlende, aus dem Schaltschrank angesaugte Luft von oben her der einen Teil der die Kammern abteilenden Trennwand bildenden Tauschereinheit zugeführt wird, während Umlenkbleche die aus der Tauschereinheit austretende gekühlte Luft wieder von oben her dem Gebläse zuführen und über den direkt mit der Luftaustrittsöffnung gekoppelten Gebläseausgang in den Schaltschrank zurückgeführt wird. Diese Luftführung in dem Luft-Wasser-Wärmetauscher führt nicht nur zu einem komplizierten Gehäuseaufbau, die Luftbeaufschlagung der Tauschereinheit und die Abführung des Kondenswassers sind nicht optimal.

Es ist Aufgabe der Erfindung, einen Luft-Wasser-Wärmetauscher der eingangs erwähnten Art zu schaffen, bei dem die Luftbeaufschlagung der Tauschereinheit und die Kondenswasserabführung verbessert sind.

Diese Aufgabe wird nach der Erfindung dadurch gelöst, daß in der Eingangskammer das Gebläse untergebracht ist, das über die zugeordnete Luftansaug-Öffnung im Boden der Wanne Luft ansaugt und über seinen Luftaustritt und einen Durchbruch in der Trennwand die angesaugte Luft der in der Ausgangskammer untergebrachten Tauschereinheit von unten nach oben zuführt, und daß die die Tauschereinheit passierende, gekühlte Luft über einen Tropfenabscheider und Umlenkbleche der zugeordneten Luftaustritts-Öffnung im Boden der Wanne zuführbar ist.

Durch die geänderte Luftführung wird vor der Tauschereinheit ein Überdruck erzeugt. Dadurch wird, im Vergleich zur bekannten Unterdruckausführung, bei relativ geringen Abständen zwischen der Tauschereinheit und dem Gebläse, eine bessere Luftbeaufschlagung des Lamellenpaketes der Tauschereinheit bewirkt.

Außerdem ergibt sich durch die geänderte Luftführung ein anderer Geschwindigkeitsverlauf der Luft entlang des Wärmetauschers: die den Wärmeaustauscher verlassende Luft hat eine wesentlich kleinere Geschwindigkeit als bei der bisherigen Luftführung. Die sich im Wärmeaustauscher bildenden Kondenswassertropfen können somit viel einfacher, unter Einwirkung der Gravitationskraft, zur Wanne hin tropfen, um über den Kondenswasser-Ablauf nach draußen abgeführt zu werden. Die Gefahr des Herausreißens von Kondenswassertropfen aus dem Wärmeaustauscher ist hier viel geringer, bei gleiche Geblasen, als bei bisheriger Luftführung, da sich bei der geänderten Luftführung das Kondenswasser bzw. Leckwasser auf der Überdruckseite sammelt. Die Abflußrichtung entspricht somit der Richtung der Luftströmung. Der Einsatz eines Fließes, um, wie bisher, das Kondenswasser gegen die Luftströmung nach außen abzuführen, entfällt daher.

Auf Umlenkbleche oder Leitbleche in der Eingangskammer kann nach einer Ausgestaltung dadurch verzichtet werden, daß das Gebläse axial Luft ansaugt und über einen tangential gerichteten Luftaustritt abgibt, der mit der Trennwand verbunden ist.

Ist nach einer Ausgestaltung vorgesehen, daß die Trennwand leicht zur Seite mit der Luftaustritts-Öffnung geneigt ist und daß die Tauschereinheit im Abstand zum Boden der Wanne senkrecht an der Trennwand unter Freilassung des Durchbruches in der Trennwand angebracht ist, dann kann die angesaugte Luft auf einfachste Art von unten nach oben über die Tauschereinheit geleitet werden. Ist dabei vorgesehen, daß der Boden unterhalb der Tauschereinheit in Richtung zur Luftaustritts-Öffnung hin fallend ausgebildet ist und die Wanne in diesem Bereich mit einem Kondenswasser-Ablauf versehen ist, dann wird die Wanne als Auffangwanne für das Kondenswasser mitverwendet.

Damit das in der Wanne aufgefangene Kondenswasser in den Schaltschrank abfließen kann, sieht eine Weiterbildung vor, daß die Luftansaug-Öffnung und die Luftaustritts-Öffnung mit über den Boden der Wanne ragenden Begrenzungswänden umschlossen sind.

Die Bremswirkung des Tropfenabscheiders und die Passage von Kondenswasser bzw. Leckwasser wird nach einer Ausgestaltung dadurch erhöht bzw. verhindert, daß der Tropfenabscheider als Drahtgewirk-Tropfenabscheider ausgebildet ist und die Oberseite, d.h. Ausgangsseite, der Tauschereinheit großflächig abdeckt.

Die vollständige Abteilung des von der Wanne und der Haube umschlossenen Raumes wird dadurch erreicht, daß auch die Wanne mittels eines Trennsteges entsprechend der Eingangs- und Ausgangskammer unterteilt ist und daß die Trennwand sich an diesen Trennsteg anschließt und den durch die Haube umschlossenen Raum mit dem Trennsteg in die Eingangs- und Ausgangskammer unterteilt.

Die Erfindung wird anhand eines in den Zeichnungen dargestellten Ausführungsbeispiels näher erläutert. Es zeigen:
- Fig. 1: in Draufsicht die Wanne des Luft-Wasser-Wärmetauschers, die mit der Deckwand des Schaltschrankes verbunden wird, und
- Fig. 2: eine schematische Seitenansicht des Luft-Wasser-Wärmetauschers, die den inneren Aufbau erkennen läßt.

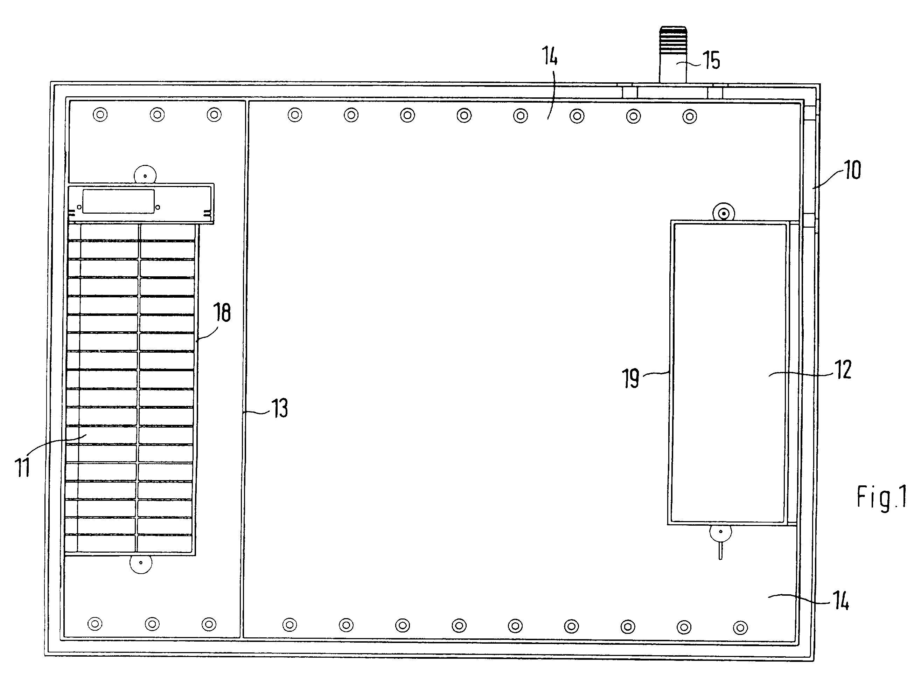

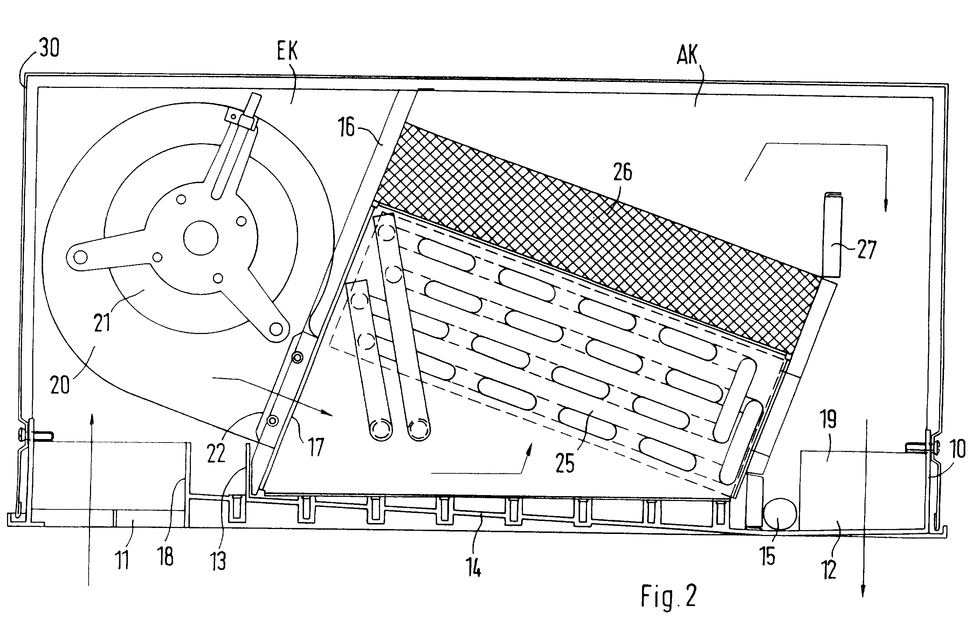

Die in Fig. 1 dargestellte Wanne 10 hat einen umlaufenden Doppelrand, der eine Aufnahme für die Haube bildet. Der Wannenraum wird durch eine am Boden 14 angeformte Trennwand 13 unterteilt, wobei der kleinere Raum mit einer durch Stege gitterartig ausgebildeten Luftansaug-Öffnung 11 versehen ist. Im größeren Raum ist in den Boden 14 der Wanne 10 eine Luftaustritts-Öffnung 12 eingebracht. Die Luftansaug-Öffnung 11 und die Luftaustritts-Öffnung 12 sind im Bereich der Schmalseiten der im Ausführungsbeispiel rechteckförmigen Wanne 10 angeordnet und ebenfalls rechteckförmig gestaltet. Begrenzungswände 18 und 19 umschließen die Luftansaug-Öffnung 11 und die Luftaustritts-Öffnung 12, damit das von der Wanne 10 aufgefangene Kondenswasser nicht in den Schaltschrank zurückfließen kann, sondern über den im Bereich der Luftaustritts-Öffnung 12 angeformten Kondenswasser-Ablauf 15 aus der Wanne 10 abfließen kann. Der Boden 14 der Wanne 10 ist dabei in Richtung zur Luftaustritts-Öffnung 12 hin abfallend ausgelegt, wie der Fig. 2 zu entnehmen ist.

An den Trennsteg 13 der Wanne 10 schließt sich eine zur Luftaustritts-Öffnung 12 hin geneigte Trennwand 16 an, die den durch die Haube 30 und die Wanne 10 umschlossenen Gehäuseraum in eine Eingangskammer EK und eine Ausgangskammer AK unterteilt. In der Eingangskammer EK ist ein Gebläse 20 untergebracht, das axial die Luft ansaugt und über einen Gebläseausgang 22 abgibt. Die axiale Ansaugöffnung 21 des Gebläses 20 steht über die Luftansaugöffnung 11 mit dem Schaltschrank-Innenraum in Verbindung, wenn der Luft-Wasser-Wärmetauscher auf der Deckwand des Schaltschrankes befestigt ist und die Deckwand mit entsprechenden Öffnungen versehen ist, die mit der Luftansaug-Öffnung 11 und der Luftaustritts-Öffnung 12 zur Deckung gebracht sind.

Der als Stutzen ausgebildete Luftausgang 22 des Gebläses 20 ist mit der Trennwand 16 verbunden, die an der Verbindungsstelle mit einem angepaßten Durchbruch 17 versehen ist. Über diesem Durchbruch 17 ist in der Ausgangskammer AK eine Tauschereinheit 25 mit der Trennwand 13 verbunden. Diese Tauschereinheit 25 erhält über Leitungen die Kühlflüssigkeit, welche die Kühlschlangen der Tauschereinheit 25 durchströmt. Die von dem Gebläse 20 über den Durchbruch 17 der Trennwand 16 zugeführte Luft wird über den unterhalb der Tauschereinheit 25 freibleibenden Raum der Ausgangskammer AK zugeführt und passiert die Tauschereinheit 25 von unten nach oben über die in der Tauschereinheit 25 geschaffenen Kanäle. Die Ausgangsseite der Tauschereinheit 25 liegt oben und wird mittels eines als Drahtgewirke-Tropfenabscheider ausgebildeten Tropfenabscheiders 26 großflächig abgedeckt, so daß der die Tauschereinheit 25 passierende Luftstrom gebildet und evtl. mitgeführtes Kondenswasser oder Leckwasser zurückgehalten wird. Unterhalb der Tauschereinheit 25 wird das aufgefangene Wasser über den zur Luftaustritts-Öffnung 12 hin geneigten Boden 14 dem Kondenswasser-Ablauf 15 zugeführt. Die die Tauschereinheit 25 verlassende gekühlte Luft wird über das als Befestigungsmittel für die Tauschereinheit 25 dienende Umlenkblech 27 in einer Art Kanal der Luftaustritts-Öffnung 12 zugeführt und gelangt über diese in den Schaltschrank-lnnenraum.

Die Tauschereinheit 25 kann zusätzlich auch am Boden 14 der Wanne 10 befestigt sein, der dann mit angeformten Schraubhülsen versehen ist.

Bei dieser Aufteilung des Luft-Wasser-Wärmetauschers herrscht in der Ausgangskammer AK im Stauraum unter der Tauschereinheit der höhere Druck. Dies wirkt sich dahingehend aus, daß die Luftführung und die Abführung von Kondenswasser bzw. Leckwasser verbessert sind.

## Patentansprüche

1. Luft-Wasser-Wärmetauscher mit einer Tauschereinheit und einem Gebläse, die in einem aus Wanne und Haube gebildeten und mit der Deckwand eines Schaltschrankes verbindbaren Gehäuse untergebracht sind, wobei die Deckwand des Schaltschrankes und der Boden der Wanne mit zur Deckung bringbaren Öffnungen versehen sind und wobei das Gehäuse mittels Trennwänden in eine Eingangs- und eine Ausgangskammer unterteilt sind, die mit den Öffnungen im Boden der Wanne in Verbindung stehen,
dadurch gekennzeichnet,
daß in der Eingangskammer (EK) das Gebläse (20) untergebracht ist, das über die zugeordnete Luftansaug-Öffnung (11) im Boden der Wanne (10) Luft ansaugt und über seinen Luftaustritt (22) und einen Durchbruch (17) in der Trennwand (16) die angesaugte Luft der in der Ausgangskammer (AK) untergebrachten Tauschereinheit (25) von unten nach oben zuführt, und
daß die die Tauschereinheit (25) passierende, gekühlte Luft über einen Tropfenabscheider (26) und Umlenkbleche (27) der zugeordneten Luftaustritts-Öffnung (12) im Boden der Wanne (10) zuführbar ist.

2. Luft-Wasser-Wärmetauscher nach Anspruch 1,
dadurch gekennzeichnet,
daß das Gebläse (20) axial Luft ansaugt und über einen tangential gerichteten Luftaustritt (22) abgibt, der mit der Trennwand (16) verbunden ist.

3. Luft-Wasser-Wärmetauscher nach Anspruch 1 oder 2,
dadurch gekennzeichnet,
daß die Trennwand (16) leicht zur Seite mit der Luftaustritts-Öffnung (12) geneigt ist und
daß die Tauschereinheit (25) im Abstand zum Boden der Wanne (10) senkrecht an der Trennwand (16) unter Freilassung des Durchbruches (17) in der Trennwand (16) angebracht ist.

4. Luft-Wasser-Wärmetauscher nach einem der Ansprüche 1 bis 3,
dadurch gekennzeichnet,
daß der Boden (14) unterhalb der Tauschereinheit (25) in Richtung zur Luftaustritts-Öffnung (12) hin fallend ausgebildet ist und die Wanne (10) in diesem Bereich mit einem Kondenswasser-Ablauf (15) versehen ist.

5. Luft-Wasser-Wärmetauscher nach einem der Ansprüche 1 bis 4,
dadurch gekennzeichnet,
daß die Luftansaug-Öffnung (11) und die Luftaustritts-Öffnung (12) mit über den Boden (14) der Wanne (10) ragenden Begrenzungswänden (18,19) umschlossen sind.

6. Luft-Wasser-Wärmetauscher nach einem der Ansprüche 1 bis 5,
dadurch gekennzeichnet,
daß der Tropfenabscheider (26) als Drahtgewirk-Tropfenabscheider ausgebildet ist und die Oberseite, d.h. Ausgangsseite, der Tauschereinheit (25) großflächig abdeckt.

7. Luft-Wasser-Wärmetauscher nach einem der Ansprüche 1 bis 6,
dadurch gekennzeichnet,
daß auch die Wanne (10) mittels eines Trennsteges (13) entsprechend der Eingangs- und Ausgangskammer (EK, AK) unterteilt ist und
daß die Trennwand (16) sich an diesen Trennsteg (13) anschließt und den durch die Haube (30) umschlossenen Raum mit dem Trennsteg (13) in die Eingangs- und Ausgangskammer (EK, AK) unterteilt.

## Claims

1. Air-water heat exchanger, including an exchanger unit and a fan which are accommodated in a housing formed from a tray and hood and connectable to the top wall of a switchgear cabinet, the top wall of the switchgear cabinet and the base of the tray being provided with coinciding apertures, and the housing being divided into an input chamber and an output chamber by means of dividing walls, which chambers communicate with the apertures in the base of the tray, characterised in that the fan (20) is accommodated in the input chamber (EK), draws-in air via the associated air-intake aperture (11) in the base of the tray (10) and supplies the drawn-in air upwardly from below to the exchanger unit (25), accommodated in the output chamber (AK), via its air outlet (22) and an opening (17) in the dividing wall (16), and in that the cooled air, which passes through the exchanger unit (25), is suppliable to the associated air outlet aperture (12) in the base of the tray (10) via a droplet separator (26) and baffles (27).

2. Air-water heat exchanger according to claim 1, characterised in that the fan (20) draws-in air axially and transmits it via a tangentially orientated air outlet (22), which is connected to the dividing wall (16).

3. Air-water heat exchanger according to claim 1 or 2, characterised in that the dividing wall (16) is slightly inclined relative to the side provided with the air-outlet aperture (12), and in that the exchanger unit (25) is mounted perpendicularly on the dividing wall (16) at a spacing from the base of the tray (10), so as to leave the opening (17) in the dividing wall (16) free.

4. Air-water heat exchanger according to one of claims 1 to 3, characterised in that the base (14) below the exchanger unit (25) is configured to drop towards the air-outlet aperture (12), and the tray (10) is provided in this region with an outlet for condensation water (15).

5. Air-water heat exchanger according to one of claims 1 to 4, characterised in that the air-intake aperture (11) and the air-outlet aperture (12) are surrounded by boundary walls (18,19) protruding beyond the base (14) of the tray (10).

6. Air-water heat exchanger according to one of claims 1 to 5, characterised in that the droplet separator (26) is configured as a wire mesh droplet separator and fully covers the upper surface, i.e. output side, of the exchanger unit (25).

7. Air-water heat exchanger according to one of claims 1 to 6, characterised in that the tray (10) is also divided by means of a dividing web (13) corresponding to the input and output chambers (EK, AK), and in that the dividing wall (16) communicates with this dividing web (13) and divides the area, surrounded by the hood (30), into the input and output chambers (EK, AK) with the dividing web (13).

## Revendications

1. Echangeur de chaleur air-eau pour armoire de distribution avec une unité d'échangeur et une soufflerie, qui est logé dans un boîtier constitué par une cuve et un capot, lequel boîtier pouvant être relié à une paroi de couverture d'une armoire de distribution, où la paroi de couverture de l'armoire de distribution et le fond de la cuve présentent des ouvertures pouvant être mises en alignement et où le boîtier est au moyen de parois de séparation partagé en une chambre d'entrée et en une chambre de sortie, chambres qui sont en communication avec les ouvertures dans le fond de la cuve,
caractérisé en ce que la soufflerie (20) est logée dans la chambre d'entrée (EK), soufflerie qui par l'intermédiaire de l'ouverture d'aspiration (11) dans le fond de la cuve aspire de l'air et qui par l'intermédiaire de sa sortie d'air (22) et d'un percement (17) dans la paroi de séparation (16) alimente de bas vers le haut l'air aspiré à l'unité d'échangeur (25) installée dans la chambre de sortie (AK), et
en ce que l'air refroidi qui vient de passer au travers l'unité d'échangeur (25) peut par l'intermédiaire d'un séparateur de gouttes (26) et de tôles de déviation (27) être alimenté à l'ouverture d'échappement d'air (12) dans le fond de la cuve (10).

2. Echangeur de chaleur air-eau suivant la revendication 1,
caractérisé
en ce que la soufflerie (20) aspire l'air en direction axiale et l'éjecte par l'intermédiaire d'une sortie d'air (22) tangentielle, qui est reliée à la paroi de séparation (16).

3. Echangeur de chaleur air-eau suivant la revendication 1 ou 2,
caractérisé
en ce que la paroi de séparation (16) est légèrement inclinée vers le côté avec l'ouverture d'échappement d'air (12), et
en ce que l'unité d'échangeur d'air (25) est à distance du fond de la cuve (10) montée perpendiculairement sur la paroi de séparation (16) tout en ne couvrant pas le percement (17) dans la paroi de séparation (16).

4. Echangeur de chaleur air-eau suivant l'une quelconque des revendications de 1 à 3,
caractérisé
en ce que le fond (14) au-dessous de l'unité d'échangeur (15) est orienté en pente descendante en direction de l'ouverture d'échappement d'air (12) et en ce que la cuve (10) présente dans cette zone un conduit d'écoulement d'eau de condensation (15).

5. Echangeur de chaleur air-eau suivant l'une quelconque des revendications de 1 à 4,
caractérisé
en ce que l'ouverture d'aspiration d'air (11) et l'ouverture d'échappement d'air (12) sont enveloppées par des parois de délimitation (18, 19) faisant protubérance au-dessus du fond (14) de la cuve (10).

6. Echangeur de chaleur air-eau suivant l'une quelconque des revendications de 1 à 5,
caractérisé
en ce que me séparateur de gouttes (26) est du type à mailles métalliques et recouvre par une grande surface le côté supérieur, à savoir le côté de sortie, de l'unité d'échangeur.

7. Echangeur de chaleur air-eau suivant l'une quelconque des revendications de 1 à 6,
caractérisé
en ce que la cuve est elle aussi au moyen d'une nervure de séparation (13) partagé en concordance avec la chambre d'entrée et la chambre de sortie (EK, AK), et
en ce que la paroi de séparation (16) se raccorde à cette nervure de séparation (13) et partage par la nervure de séparation (13) le volume du capot (30) en la chambre d'entrée et la chambre de sortie (EK, AK).
